# EUROPEAN PATENT APPLICATION

(11) **EP 2 757 690 A2**
(43) Date of publication of application: **23.07.2014**
(21) Application number: 14151430.7
(22) Date of filing: 16.01.2014
(51) Int. Cl.: H03K 19/018

(54) **Low power self-limiting input circuit**

(30) Priority: 17.01.2013 US 201313743394
(71) Applicant: Rockwell Automation Technologies, Inc., Mayfield Heights, OH 44124 (US)
(72) Inventor: Vazach, Joseph, Mentor, OH Ohio 44060 (US); Deloria, Terry L., Ashtabula, OH Ohio 44004 (US)
(74) Representative: Grünecker, Kinkeldey, Stockmair & Schwanhäusser

(57) **Abstract**

An input circuit (60) for an input module having a plurality of inputs is disclosed. Each input circuit (60) has a reduced number of components, providing for an increased number of inputs within an input module of comparable size to prior art input modules. Alternately, the input module may have a like number of inputs (60) in a reduced size in comparison to prior art input modules. The reduced number of components similarly reduces the power dissipated by each input circuit (60).

## Description

### BACKGROUND OF THE INVENTION

The subject matter disclosed herein relates generally to industrial controllers used in controlling industrial machines and processes and, more specifically, to an input circuit configured to receive a signal from the controlled machine or processes.

Industrial controllers are employed in industrial and commercial applications to control the operation of machines and processes. Generally the industrial controller executes a stored control program to generate output signals controlling actuators on the machine or process according to input signals received from sensors on the machine or process.

Industrial controllers differ from conventional computers in providing real-time control subject to predetermined maximum delays. In addition, industrial controllers are normally constructed in a highly modular fashion to permit their hardware to be customized according to different control applications. In this latter regard, inputs and outputs to or from the industrial controller are normally handled by input/output (I/O) modules that may be attached to the industrial controller in different combinations to provide for the necessary electrical interface to the controlled machinery. Each input module typically includes a separate input circuit providing a physical and electrical connection between one of the sensors and the industrial controller. Typically the input circuits for an input module are grouped together on a circuit board for insertion into the input module.

As is known to those skilled in the art, the input circuit typically provides optical isolation between the controlled process or machine and the industrial controller. The optical isolation prevents spurious or excessive currents on the machine side from damaging the industrial controller. The input circuit must also meet certain operating standards, for example, accepting a range of input voltages and/or input currents and guaranteeing a logical true, or on, condition above a certain voltage and/or current and a logical false, or off, condition below a certain voltage and/or current. Thus, input circuits have been developed to satisfy these operating standards.

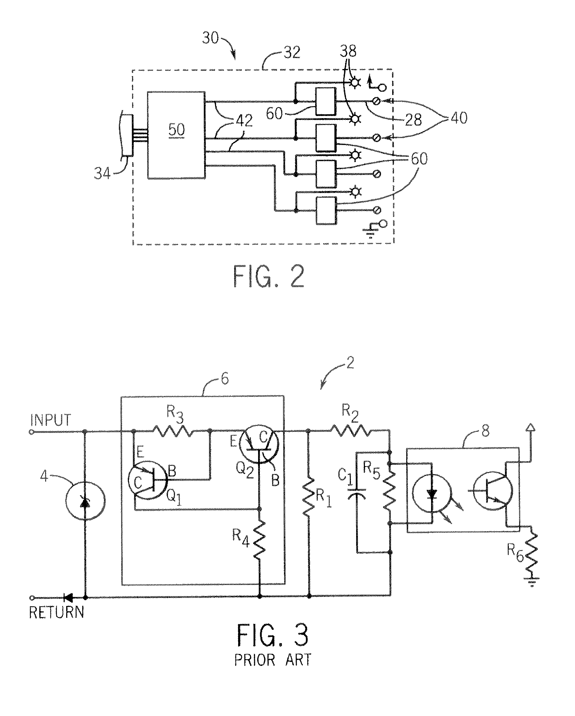

Referring to Fig. 3, an individual prior art input circuit 2 is illustrated. The prior art input circuit 2 includes a zener diode 4, operating as a surge suppressor to limit the magnitude of voltage seen by the rest of the input circuit 2. A current source 6 includes two transistors Q1, Q2 and two resistors R3, R4 and is configured to control the current provided to the rest of the input circuit 2. The input circuit 2 further includes two current limiting resistors R1, R2 and a filter circuit, including the capacitor C1 and resistor R5, which provides an input voltage to the opto-coupler 8. As illustrated, the circuit includes twelve total components, each component dissipating some amount of power. In addition, a circuit board on which the input circuit 2 would be mounted requires space for placement of each of the twelve components and for interconnections between the components.

As the complexity of the controlled machine or process increases, an increasing number of sensors are provided to monitor operation. As a result, the industrial controller requires a corresponding increase in the number of input circuits configured to receive input signals from each of the sensors. The number of input modules and/or the number of input circuits per input module must also increase. Increasing the number of input modules increases the space required in a control enclosure and increasing the number of input circuits in an input module increases the power dissipated in the module. At least a portion of the power dissipated in each module is dissipated as heat, requiring additional heat sinks, fans, or other cooling methods to transfer the extra heat from the input module. Thus, it would be desirable to provide an input circuit having lower power consumption and which requires less space on a circuit board.

### BRIEF DESCRIPTION OF THE INVENTION

The subject matter disclosed herein describes an input circuit for an input module having a plurality of inputs. Each input circuit has a reduced number of components, providing an increased number of inputs within an input module of comparable size to prior art input modules or providing an input module having a like number of inputs with a reduced size in comparison to prior art input modules. The reduced number of components similarly reduces the power dissipated by each input circuit.

According to one embodiment of the invention, an input circuit for an industrial controller includes a first terminal and a second terminal configured to receive a voltage potential, and the first terminal is configured to be a positive terminal for the voltage potential with respect to the second terminal. A zener diode having a cathode and an anode is electrically connected via the cathode to the first terminal. The input circuit further includes a current limit diode having a cathode and an anode and an opto-coupler having a light emitter and a photosensor. The anode of the current limit diode is electrically connected to the anode of the zener diode, and the light emitter is electrically connected in series between the cathode of the current limit diode and the second terminal.

According to another embodiment of the invention, an input circuit for an input module in an industrial controller includes an input configured to receive a range of direct current (DC) voltages, a zener diode electrically connected to the input to operate in a breakdown region when the DC voltage is applied to the input, a current limit diode electrically connected in series with the zener diode to operate in a current limiting mode when the DC voltage is applied to the input, and an opto-coupler having an input and an optically isolated output. The input of the opto-coupler is electrically connected to the series-connected zener diode and current limit diode and the optically isolated output of the opto-coupler generates a signal that corresponds to a logical true when the DC voltage is applied to the input and a logical false when the DC voltage is removed from the input.

These and other advantages and features of the invention will become apparent to those skilled in the art from the detailed description and the accompanying drawings. It should be understood, however, that the detailed description and accompanying drawings, while indicating preferred embodiments of the present invention, are given by way of illustration and not of limitation. Many changes and modifications may be made within the scope of the present invention without departing from the spirit thereof, and the invention includes all such modifications.

### BRIEF DESCRIPTION OF THE DRAWINGS

Various exemplary embodiments of the subject matter disclosed herein are illustrated in the accompanying drawings in which like reference numerals represent like parts throughout, and in which:
FIG. 1 is an isometric exploded view of an exemplary industrial controller illustrating an input module incorporating one embodiment of the invention;
FIG. 2 is a block diagram of a simplified input module of Fig. 1 providing multiple DC input circuits according to one embodiment of the present invention;
FIG. 3 is a schematic representation of a prior art input circuit;
FIG. 4 is a schematic representation of an input circuit according to one embodiment of the present invention; and
FIG. 5 is a graphical representation comparing the current drawn at varying voltages by each of the input circuits in Figs. 3 and 4.

In describing the various embodiments of the invention which are illustrated in the drawings, specific terminology will be resorted to for the sake of clarity. However, it is not intended that the invention be limited to the specific terms so selected and it is understood that each specific term includes all technical equivalents which operate in a similar manner to accomplish a similar purpose. For example, the word "connected," "attached," or terms similar thereto are often used. They are not limited to direct connection but include connection through other elements where such connection its recognized as being equivalent by those skilled in the art.

### DETAILED DESCRIPTION OF THE PREFERRED EMBODIMENTS

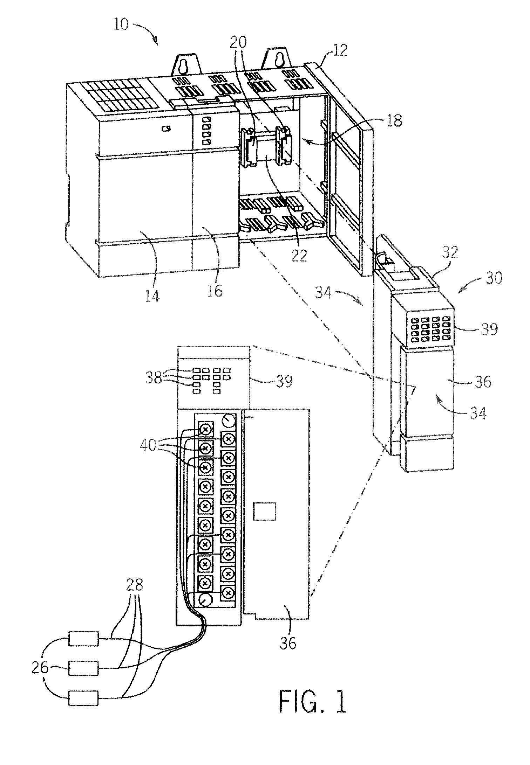

Turning initially to Fig. 1, an exemplary industrial controller 10 incorporating one embodiment of the present invention includes at least one input module 30. The input module 30 is depicted in a first embodiment implementing "chassis I/O" where the input module 30 has a housing 32 that may be slidably received within a chassis 12 along with other input modules (not shown), output modules (not shown) and/or other modules including a power supply 14 and a programmable logic controller 16. The chassis 12 may have a backplane 18 providing a set of releasable electrical connectors 20 interconnected by a backplane bus 22 extending along a rear wall of the chassis 12. A corresponding connector 34 on the rear of the housing 32 of the input module 30 mates with the releasable connectors 20 when the input module 30 is placed within the chassis 12 providing electrical connection, for example, between the programmable logic controller 16 and the circuitry of the input module 30. The bus 22 is typically a highspeed serial bus providing efficient multi-bit communication. The other modules of the industrial controller 10, such as the power supply 14, programmable logic controller 16, and other input and/or output modules (not shown) may have similar connectors, 20 and 34, for this purpose.

The front faceplate 34 of the input module 30 may open by means of a swinging door 36 to reveal a set of screw terminals 40 to which wires may be connected to connect internal input circuits of the input module 30 to various sensors 26 or other devices providing input signals 28 corresponding to the operating status of a controlled process. Indicator lights 38 correspond to each of the different input circuits and hence to particular input terminals 40 and are positioned to be visible through a bezel 39 on the front faceplate 34.

Referring now to Fig. 2, the input module 30 receives the input signals 28 at the input terminals 40. Each input signal 28 is converted by an input circuit 60 to a digital signal 42. According to one embodiment of the invention, each digital signal 42 represents a logical true or logical false state, where the logically true state is a positive voltage and the logically false is a nominally zero voltage. The indicator lights 38 are connected to the digital signals 42 by appropriate amplification circuitry to provide a visual indication to the user of the state of the particular signal 42. In addition, the digital signals 42 are each provided to an encoder circuit 50 which receives the digital signals 42 and converts them to a format suitable for communication to the programmable logic controller 16 via the backplane 18 and the connector 34 on the rear of the housing 32 of the input module 30. While only four input circuits 60 are shown, an input module 30 may have eight, sixteen, thirty-two, or various other numbers of input circuits 60 and a corresponding set of input terminals 40 and input circuits 60.

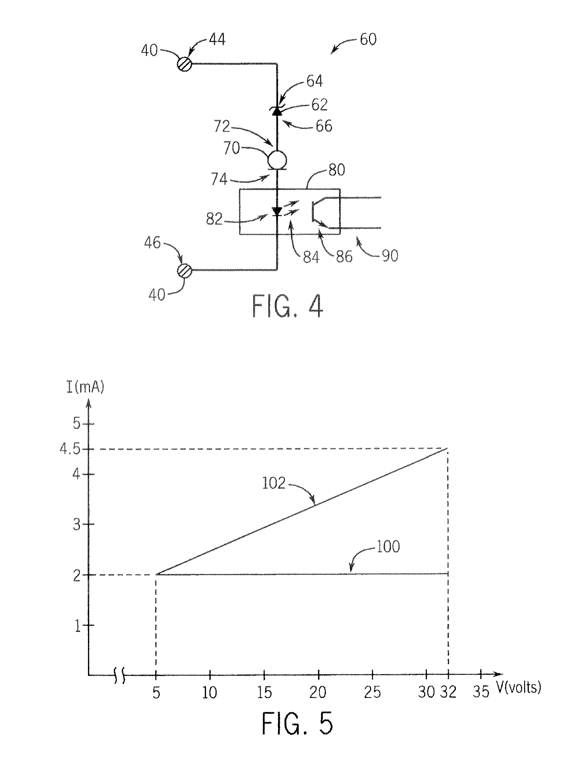

Turning next to Fig. 4, the input circuit 60 according to one embodiment of the invention includes a pair of input terminals 40. A first terminal 44 is configured to receive the input signal, and a second terminal 46 is configured to provide the return path, completing the circuit between the device 26 providing the input signal 28 and the input module 30. Optionally, the second terminal 46 may be a ground terminal or a common terminal, where a common terminal is generally about zero volts but may not be directly connected to the ground. According to still another embodiment, the second terminal may be internal to the input module 30 and a common connection made between the second terminal 46 of multiple input circuits 60. The input circuit 60 further includes a zener diode 62, a current limit diode 70, and an opto-coupler 80, also referred to as an optical isolator. The zener diode 62 includes a cathode 64 and an anode 66, where the cathode 64 is electrically connected to the first terminal 44. The current limit diode 70 includes an anode 72 and a cathode 74, where the anode 72 of the current limit diode 70 is electrically connected to the anode 66 of the zener diode 62. The opto-coupler 80 includes a light emitter 82, such as a light emitting diode (LED), a photosensor 86, and a dedicated light path 84 between the light emitter 82 and the photosensor 86. The light emitter is electrically connected in series between the cathode 74 of the current limit diode 70 and the second terminal 46. The output 90 of the photosensor 86 transmits the digital signal 42

In operation, a device 26 generates an input signal 28 corresponding to the operating status of the controlled machine or process. The input signal 28 is transmitted to the one of the input terminals 40 of the input module 30. The input signal 28 is a direct current (DC) voltage preferably in the range of 10-32 VDC and is received at the first terminal 44. The amplitude of current for the input signal is preferably greater than or equal to 2 mA. The second terminal 46 is connected to a common voltage potential, which is typically near zero volts. According to one embodiment of the invention, the second terminal is connected to an earth ground.

When the input signal 28 is present at the first terminal 44, the voltage potential between the first terminal 44 and the second terminal 46 causes the zener diode 62 to operate in its breakdown region. During operation in the breakdown region, the voltage potential across the zener diode 62 is greater than its breakdown voltage and the zener diode allows current to flow in the reverse direction through the diode. According to one embodiment of the invention, a breakdown voltage of approximately 3 VDC is selected. However, zener diodes of varying breakdown voltages may be selected without deviating from the scope of the invention. Thus, the zener diode 62 blocks current flow through the input circuit 60 when the voltage potential between the first and second terminals 44 and 46, respectively, is less than the breakdown voltage and permits current flow through the input circuit 60 when the voltage potential between the first and second terminals 44 and 46, respectively, is greater than the breakdown voltage.

When the input signal 28 is present at the first terminal 44, the voltage potential between the first terminal 44 and the second terminal 46 also causes the current limit diode 70 to operate in its current limiting region. A current limit diode 70 requires a minimum voltage at which the current limit diode 70 begins to conduct current. With a small increase in the voltage potential across the current limit diode 70 from the minimum voltage, the magnitude of current conducted through the current limit diode 70 quickly rises from zero to a maximum current value. As the voltage potential across the current limit diode 70 continues to increase, the magnitude of current conducted through the current limit diode 70 remains substantially constant. The magnitude of current conducted by the current limit diode 70 is chosen according to the application requirements. According to one embodiment of the invention, the current limit diode 70 is selected to conduct about 2 mA, corresponding to a desired forward current for the LED light emitter 82 in the opto-coupler 80. However, current limit diodes of varying current ratings may be selected without deviating from the scope of the invention.

The opto-coupler 80 provides an isolated digital signal 42 suitable for transmission to the programmable logic controller 16. With a suitable voltage potential, typically about 0.7 VDC, and forward current present at the LED light emitter 82, the LED 82 generates photons which are, in turn, transmitted to the photosensor 86 via the dedicated light path 84. If the voltage potential at the LED light emitter 82 increases, the LED 82 continues to generate a substantially constant stream of photons such that the isolated digital signal 42 is not affected by sudden transient voltage spikes across the LED 82.

The input circuit 60, according to one embodiment of the present invention, converts a range of DC input voltages to an isolated digital signal 42 with fewer components and at a lower power level than the prior art circuit 2, illustrated in Fig. 3. A comparison of circuit elements shows that the prior art circuit 2 required twelve devices while the input circuit 60 according to the illustrated embodiment requires just three devices. Thus, the input circuit 60 according to the illustrated embodiment of the present invention realizes a significant reduction in area on a circuit board to mount each of the devices and to run electrical traces, or interconnections, between the devices.

Referring also to Fig. 4, the input circuit 60 according to the illustrated embodiment of the present invention operates with reduced power consumption compared to the prior art circuit 2. The graph line 100 shows the current conducted in the input circuit 60 of the illustrated embodiment of the present invention. The current limit diode 70 maintains a substantially constant 2 mA across the range of operating voltages (e.g., 5-32 VDC) that may be present at the input terminals 40. In contrast, the prior art circuit conducted 2 mA at 5 VDC and slowly increased in current to about 4.5 mA at 32 VDC. As is known in the art, the power consumed in a DC circuit is determined by multiplying the amplitude of the current by the amplitude of the voltage. Thus, over the same range of voltages, the prior art circuit 2 conducted more current, resulting in greater power losses, than the input circuit 60 according to the illustrated embodiment of the present invention.

It should be understood that the invention is not limited in its application to the details of construction and arrangements of the components set forth herein. The invention is capable of other embodiments and of being practiced or carried out in various ways. Variations and modifcations of the foregoing are within the scope of the present invention. It also being understood that the invention disclosed and defined herein extends to all alternative combinations of two or more of the individual features mentioned or evident from the text and/or drawings. All of these different combinations constitute various alternative aspects of the present invention. The embodiments described herein explain the best modes known for practicing the invention and will enable others skilled in the art to utilize the invention

## Claims

1. An input circuit for an industrial controller, comprising:
a first terminal and a second terminal configured to receive a voltage potential, wherein the first terminal is configured to be a positive terminal for the voltage potential with respect to the second terminal;
a zener diode having a cathode and an anode, the cathode electrically connected to the first terminal;
a current limit diode having a cathode and an anode, the anode of the current limit diode electrically connected to the anode of the zener diode; and
an opto-coupler having a light emitter and a photosensor, the light emitter electrically connected in series between the cathode of the current limit diode and the second terminal.

2. An input circuit for input module in an industrial controller, comprising:
an input configured to receive a range of direct current (DC) voltages;
a zener diode electrically connected to the input to operate in a breakdown region when the DC voltage is applied to the input;
a current limit diode electrically connected in series with the zener diode to operate in a current limiting mode when the DC voltage is applied to the input; and
an opto-coupler having an input and an optically isolated output wherein the input is electrically connected to the series-connected zener diode and current limit diode and the optically isolated output generates a signal that corresponds to a logical true when the DC voltage is applied to the input and a logical false when the DC voltage is removed from the input.

3. The input circuit of claim 2 wherein the range of DC voltages is between 10 volts and 32 volts.

4. The input circuit of claim 3 wherein an amplitude of current at the input is greater than or equal to 2 milliamps.

5. The input circuit of claim 2 wherein the input includes a first terminal and a second terminal.

6. The input circuit of claim 5 wherein the first terminal is configured to receive a voltage potential within the range of DC voltages and the second terminal is configured to be connected to one of a common and a ground.

7. The input circuit of claim 6 wherein the second terminal is a shared connection between the input circuit and at least one other input circuit on the input module.

8. The input circuit of claim 6 wherein each of the and second terminals are configured to receive an electrical conductor external to the input module.

9. The input circuit of claim 6 wherein the first terminal is configured to receive an electrical conductor external to the input module and the second terminal is configured to be connected internal to the input module.
